# EUROPEAN PATENT APPLICATION

(11) **EP 4 614 575 A1**
(43) Date of publication of application: **10.09.2025**
(21) Application number: 23884547.3
(22) Date of filing: 08.10.2023
(51) Int. Cl.: H01L 27/15, H01L 33/50, H01L 33/46, H01L 25/16

(54) **MICRO-DISPLAY CHIP AND MANUFACTURING METHOD THEREFOR**

(30) Priority: 01.11.2022 CN 202211356839
(71) Applicant: Raysolve Optoelectronics (Suzhou) Co., Ltd., Suzhou, Jiangsu 215000 (CN)
(72) Inventor: ZHANG, Xu, Suzhou, Jiangsu 215000 (CN); CHONG, Wing Cheung, Suzhou, Jiangsu 215000 (CN); LU, Ziyuan, Suzhou, Jiangsu 215000 (CN)
(74) Representative: Murgitroyd & Company
(86) International application number: PCT/CN2023/123419
(87) International publication number: WO 2024/093615

(57) **Abstract**

The present disclosure relates to the field of optical films, and in particular to a micro-display chip and a preparation method thereof. The micro-display chip includes: a self-luminescence layer, emitting a first color light; a wavelength conversion layer, includes at least a first wavelength conversion unit, which is superimposed with light emitting units to emit a second color light; and a first transmitting-and-reflecting layer and/or a second transmitting-and-reflecting layer; the first transmitting-and-reflecting layer is disposed between the self-luminescence layer and the wavelength conversion layer; the second transmitting-and-reflecting layer is disposed on another surface of the wavelength conversion layer; the first transmitting-and-reflecting layer is set to have low reflectivity and high transmissivity for the first color light and high reflectivity and low transmissivity for the second color light, and the second transmitting-and-reflecting layer is set to have high reflectivity and low transmissivity for the first color light and low reflectivity and high transmissivity for the second color light. The micro-display chip of the present disclosure can effectively improve the absorbance and color purity of conversion light, thereby obtaining a brighter and purer conversion spectrum.

## Description

### CROSS-REFERENCE TO RELATED APPLICATIONS

### TECHNICAL FIELD

The present disclosure relates to the field of optical films, and in particular, to a micro-display chip and a preparation method thereof.

### BACKGROUND

Micro LED display technology is an effective complement to current mainstream display technologies, filling the vacancies and shortcomings of the current mainstream display technologies in applications. After tiling, it can meet the needs of large-size displays. The high brightness, wide color gamut, and high contrast performance achieved by its pixel-level light control can meet the needs of outdoor, semi-outdoor, and cinema scenarios. With its ultra-small grain size, it can achieve the requirement of thousands of pixels density. The characteristics of self-luminescence and material stability of the Micro LED display gives it advantages in response time, wide-temperature operation and storage, meeting the real-time and reliability requirements of airborne main displays such as those in aircraft. Utilizing the nanosecond-level response time characteristic of the Micro LED display technology, it is possible to achieve true naked-eye 3D display.

Although the Micro LED display technology has significant advantages, the technology is not yet mature, and achieving high-performance and high-brightness Micro LED display currently faces issues such as low color purity and low conversion brightness.

Therefore, discovering a micro-display chip that improves color purity and increases conversion brightness is very important.

### SUMMARY

The purpose of the present disclosure is to overcome the above-mentioned problems existing in the conventional technology and to provide a micro-display chip and a preparation method thereof. The micro-display chip of the present disclosure can effectively improve the absorbance and color purity of conversion light, thereby obtaining a brighter and purer conversion spectrum.

The first aspect of the present disclosure provides a micro-display chip, including: a self-luminescence layer, the self-luminescence layer includes a plurality of light emitting units arranged in an array, the light emitting units are configured to emit a first color light; and a wavelength conversion layer disposed on a surface of the self-luminescence layer, the wavelength conversion layer includes a plurality of wavelength conversion units, the wavelength conversion units include at least a first wavelength conversion unit, the light emitting units superimposed with the first wavelength conversion unit emit a second color light; the micro-display chip further includes: a first transmitting-and-reflecting layer and/or a second transmitting-and-reflecting layer; the first transmitting-and-reflecting layer is configured to be disposed between the self-luminescence layer and the wavelength conversion layer; the second transmitting-and-reflecting layer is configured to be disposed on another surface of the wavelength conversion layer; and the first transmitting-and-reflecting layer is configured to have low reflectivity and high transmissivity for the first color light and high reflectivity and low transmissivity for the second color light, and the second transmitting-and-reflecting layer is configured to have high reflectivity and low transmissivity for the first color light and low reflectivity and high transmissivity for the second color light.

Optionally, the micro-display chip includes the first transmitting-and-reflecting layer (excluding the second transmitting-and-reflecting layer).

Optionally, the micro-display chip includes the second transmitting-and-reflecting layer (excluding the first transmitting-and-reflecting layer).

Optionally, the micro-display chip includes the first transmitting-and-reflecting layer and the second transmitting-and-reflecting layer.

In one embodiment, the micro-display chip further includes a driving substrate with a driving circuit, the self-luminescence layer is disposed on the driving substrate, the driving substrate is capable of individually lighting up each of the light emitting units, the light emitting units are LED units or OLED units, and a size of the light emitting units ranges from 0.1 µm to 10 µm.

In one embodiment, the first transmitting-and-reflecting layer has a reflectance of less than 5% and a transmittance of greater than 95% for the first color light.

In one embodiment, the first transmitting-and-reflecting layer has a reflectance of greater than 90% and a transmittance of less than 10% for the second color light.

In one embodiment, the second transmitting-and-reflecting layer has a reflectance of greater than 95% and a transmittance of less than 5% for the first color light.

In one embodiment, the second transmitting-and-reflecting layer has a reflectance of less than 10% and a transmittance of greater than 90% for the second color light.

In one embodiment, the wavelength conversion units further include a second wavelength conversion unit, and the light emitting units superimposed with the second wavelength conversion unit emit a third color light; the first transmitting-and-reflecting layer is further configured to have high reflectivity and low transmissivity for the third color light , and the second transmitting-and-reflecting layer is further configured to have low reflectivity and high transmissivity for the third color light.

In one embodiment, the first transmitting-and-reflecting layer has a reflectance of greater than 90% and a transmittance is less than 10% for the third color light, and the second transmitting-and-reflecting layer has a reflectance of less than 10% and a transmittance of greater than 90% for the third color light.

In one embodiment, the wavelength conversion units include quantum dots and/or phosphors.

In one embodiment, the wavelength conversion units include a photoresist.

In one embodiment, the first transmitting-and-reflecting layer and the second transmitting-and-reflecting layer are each independently a hybrid Bragg reflector or a distributed Bragg reflector; where the distributed Bragg reflector includes m periodic structures A, and each periodic structure A is formed by stacking a material A1 and a material A2, m is an integer from 4 to 9; the hybrid Bragg reflector is formed by replacing one or more layers in a periodic stacked material with another material; where the periodic stacked material includes n periodic structures B, and each periodic structure B is formed by stacking a material B1 and a material B2; the another material is one or more materials different from B1 and B2, and denoted as B3... Bx, x is an integer greater than or equal to 3; n is an integer from 4 to 9; and the materials A1, A2, B1, B2, B3... Bx are each independently selected from TiO₂, SiO₂, SiNₓ, HfO₂, MgF₂, ZrO₂, or polymethyl methacrylate.

In one embodiment, the hybrid Bragg reflector includes n1 periodic structures composed of B1 and B2 and n2 periodic structures composed of B1 or B2 and B3, and n1 + n2 = n.

In one embodiment, the hybrid Bragg reflector includes n1 periodic structures composed of TiO₂ and SiO₂ and n2 periodic structures composed of TiO₂ and MgF₂, where n1 is a positive integer from 1 to 3, n is a positive integer from 6 to 9, and n2 = n - n1; or, the hybrid Bragg reflector includes n1 periodic structures composed of TiO₂ and SiNₓ and n2 periodic structures composed of TiO₂ and MgF₂, where n1 is a positive integer from 1 to 3, n is a positive integer from 6 to 9, and n2 = n - n1.

In one embodiment, the wavelength conversion layer further includes a plurality of transmission units, the transmission units are disposed on part of the multiple light emitting units and used to transmit the first color light emitted by the corresponding light emitting units; and, the second transmitting-and-reflecting layer has vacancies at positions corresponding to the transmission units to transmit the first color light.

In one embodiment, the first color light is blue light; the wavelength conversion layer includes a plurality of transmission units, first wavelength conversion units, and second wavelength conversion units that are in one-to-one correspondence with the light emitting units and together form a periodic arrangement; where the transmission units are used to transmit the blue light; the first wavelength conversion unit is a red quantum dot film, and the light emitting units superimposed with the first wavelength conversion unit to emit red light; the second wavelength conversion unit is a green quantum dot film, and the light emitting units superimposed with the second wavelength conversion unit emit green light; and at least one transmission unit, at least one first wavelength conversion unit, and at least one second wavelength conversion unit form a pixel.

A second aspect of the present disclosure provides a preparation method for preparing a micro-display chip, the preparation method including the following steps:
(1) forming a first transmitting-and-reflecting layer on a self-luminescence layer provided with a plurality of light emitting units arranged in an array, and the first transmitting-and-reflecting layer is configured to have low reflectivity and high transmissivity for a first color light emitted by the light emitting units;
(2) forming a wavelength conversion layer on a surface of the first transmitting-and-reflecting layer, the wavelength conversion layer includes a plurality of wavelength conversion units, the wavelength conversion units include at least a first wavelength conversion unit, and the light emitting units superimposed with the first wavelength conversion unit emit a second color light; and
(3) forming a second transmitting-and-reflecting layer on surfaces of the wavelength conversion units, and the second transmitting-and-reflecting layer is configured to have high reflectivity and low transmissivity for the first color light.

In one embodiment, the preparation method further includes: providing a driving substrate with a driving circuit, and forming the self-luminescence layer on the driving substrate, the driving substrate is capable of individually lighting up each of the light emitting units, the light emitting units are LED units or OLED units, and sizes of the light emitting units ranges from 0.1 µm to 10 µm.

In one embodiment, the first transmitting-and-reflecting layer and the second transmitting-and-reflecting layer are each independently a hybrid Bragg reflector or a distributed Bragg reflector; where the distributed Bragg reflector includes m periodic structures A, each periodic structure A is formed by stacking a material A1 and a material A2, m is an integer from 4 to 9; the hybrid Bragg reflector is formed by replacing one or more layers in a periodic stacked material with another materials where the periodic stacked material includes n periodic structures B, each periodic structure B is formed by stacking a material B1 and a material B2; the another materials is one or more materials different from B1 and B2, and denoted as B3 ... Bx, x is an integer greater than or equal to 3; n is an integer from 4 to 9; and the materials A1, A2, B1, B2, B3 ... Bx are each independently selected from TiO₂, SiO₂, SiNₓ, HfO₂, MgF₂, ZrO₂, or polymethyl methacrylate.

In one embodiment, the hybrid Bragg reflector and the distributed Bragg reflector are each independently formed by one or more of vapor deposition, sputtering, or deposition.

In one embodiment, the preparation method further includes: the wavelength conversion layer is configured to further include transmission units, the transmission units are disposed on part of the multiple light emitting units and used to transmit the first color light emitted by the corresponding light emitting units; and, the second transmitting-and-reflecting layer has vacancies at positions corresponding to the transmission units to transmit the first color light.

In one embodiment, a method for forming the self-luminescence layer on the driving substrate includes: providing an LED epitaxial layer, the LED epitaxial layer includes a first doped semiconductor layer, an active layer, and a second doped semiconductor layer; forming a bonding layer on the driving substrate and/or the second doped semiconductor layer and bond the two; forming the LED unit on the LED epitaxial layer; and forming an electrical connection structure between the LED unit and the driving substrate so that the driving substrate is capable of individually lighting up each of the light emitting units.

Through the above technical solutions, the present disclosure has at least the following advantages compared to the conventional technology.

Firstly, the micro-display chip of the present disclosure can effectively improve the absorption efficiency and light extraction efficiency of the conversion layer.

Secondly, the micro-display chip of the present disclosure significantly enhances the light extraction effect for low-absorption light (such as green light), greatly improving color purity and converted light brightness.

The endpoints of the ranges and any values disclosed In this specification are not limited to the precise ranges or values, and these ranges or values should be understood to include values close to these ranges or values. For numerical ranges, the endpoint values of each range, the endpoint values of each range and individual point values, and individual point values can be combined with each other to obtain one or more new numerical ranges, which should be considered as specifically disclosed in this specification.

### BRIEF DESCRIPTION OF THE DRAWINGS

FIG. 1 shows a schematic diagram of the micro-display chip of the present disclosure.
FIG. 2 shows a schematic diagram of light propagation in the micro-display chip of the present disclosure.
FIG. 3 shows the reflection curve of the DBR and schematic diagram of the spectrum as the second transmitting-and-reflecting layer.
FIG. 4 shows the reflection curve of the HBR and schematic diagram of the spectrum as the first transmitting-and-reflecting layer.
FIG. 5 shows a schematic diagram of the micro-display chip with a LED-H1-quantum dot film-H2 structure obtained in Example 1.
FIG. 6 shows a schematic diagram of the micro-display chip with a LED-D1-quantum dot film-D2 structure obtained in Example 2.
FIG. 7 shows a schematic diagram of the micro-display chip with a LED-H1-quantum dot film-D2 structure obtained in Example 3a.
FIG. 8 shows a schematic diagram of the micro-display chip with a LED-D1-quantum dot film-H2 structure obtained in Example 3b.
FIG. 9 shows a schematic diagram of the micro-display chip with a LED-no structure-quantum dot film-D2 structure obtained in Example 3c.
FIG. 10 shows a schematic diagram of the micro-display chip with a LED-no structure-quantum dot film-H2 structure obtained in Example 3d.
FIG. 11 shows a schematic diagram of the micro-display chip with a LED-quantum dot film structure in Comparative Example 1.
FIG. 12 shows a schematic structural diagram of the layer structure of a distributed Bragg reflector (DBR).
FIG. 13 shows a schematic structural diagram of the layer structure of a hybrid Bragg reflector (HBR) in one embodiment.

### Reference numerals:

10 - the self-luminescence layer, 11 - the light emitting units, 50 - the first transmitting-and-reflecting layer, 30 - the wavelength conversion layer, 31 - the first wavelength conversion unit, 32 - the second wavelength conversion unit, 33 - the transmission units, 60 - the second transmitting-and-reflecting layer,101 - the first color light, 311 - the second color light, 321 - the third color light.

### DETAILED DESCRIPTION OF THE EMBODIMENTS

The detailed descriptions of the embodiments of the present disclosure will be described in detail below. It should be understood that the specific implementations described herein are only for illustrating and explaining the present disclosure and are not intended to limit the present disclosure. The micro-display chip will be exemplarily described below in conjunction with the drawings.

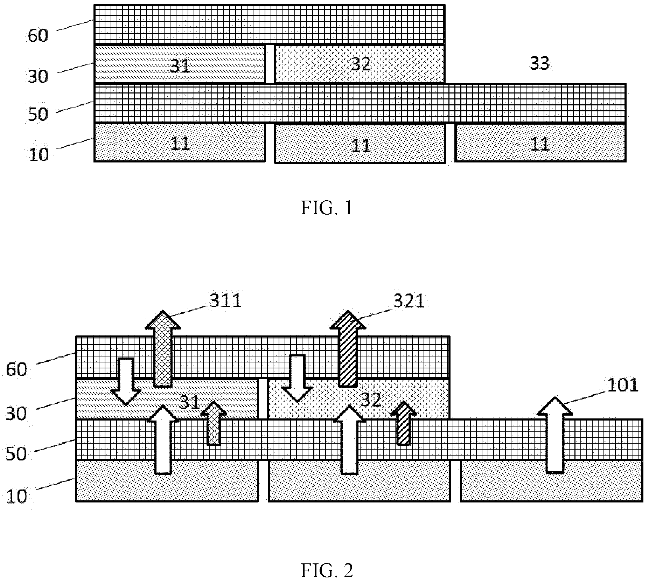

As shown in FIG. 1 and FIG. 2, a micro-display chip includes: a self-luminescence layer 10, the self-luminescence layer 10 includes a plurality of light emitting units arranged in an array, and the light emitting units are configured to emit a first color light 101; and a wavelength conversion layer 30, disposed on a surface of the self-luminescence layer 10, the wavelength conversion layer 30 includes a plurality of wavelength conversion units, the wavelength conversion units includes at least a first wavelength conversion unit 31, the light emitting units superimposed with the first wavelength conversion unit 31 emit a second color light 311; and the micro-display chip further includes: a first transmitting-and-reflecting layer 50 and/or a second transmitting-and-reflecting layer 60; the first transmitting-and-reflecting layer is configured to be disposed between the self-luminescence layer 10 and the wavelength conversion layer 30; the second transmitting-and-reflecting layer 60 is configured to be disposed on another surface of the wavelength conversion layer 30; and the first transmitting-and-reflecting layer 50 is configured to have low reflectivity and high transmissivity for the first color light 101 and high reflectivity and low transmissivity for the second color light 311, and the second transmitting-and-reflecting layer 60 is configured to have high reflectivity and low transmissivity for the first color light and low reflectivity and high transmissivity for the second color light 311.

The micro-display chip may include one or both of the first transmitting-and-reflecting layer and the second transmitting-and-reflecting layer. For example, optionally, the micro-display chip may only include the first transmitting-and-reflecting layer and exclude the second transmitting-and-reflecting layer; or may only include the second transmitting-and-reflecting layer and exclude the first transmitting-and-reflecting layer; or may include both the first transmitting-and-reflecting layer and the second transmitting-and-reflecting layer.

In one embodiment, the micro-display chip further includes a driving substrate with a driving circuit, the self-luminescence layer is disposed on the driving substrate, the driving substrate is capable of individually lighting up each of the light emitting units, the light emitting units are LED units or OLED units, and a size of the light emitting units ranges from 0.1 µm to 10 µm. The driving substrate and the self-luminescence layer may be arranged in a conventional manner in the field. In a preferred implementation, the driving substrate and the self-luminescence layer are arranged in the manner disclosed in Chinese Patent Application Publication CN112992964A.

In one embodiment, the micro-display chip includes both the first transmitting-and-reflecting layer and the second transmitting-and-reflecting layer, that is, includes a self-luminescence layer 10, a first transmitting-and-reflecting layer 50, a wavelength conversion layer 30, and a second transmitting-and-reflecting layer 60 stacked in sequence from bottom to top.

When the first transmitting-and-reflecting layer is present, it is disposed between the self-luminescence layer and the wavelength conversion layer, and is configured to have low reflectivity and high transmissivity for the first color light and high reflectivity and low transmissivity for the second color light; thereby enabling the first color light to transmit through the first transmitting-and-reflecting layer and propagate upward as much as possible while reflect back to the self-luminescence layer as little as possible, and enabling the second color light reflected from above to be reflected back in the upward propagation direction as much as possible while pass through the first transmitting-and-reflecting layer toward the self-luminescence layer as little as possible. Preparing the first transmitting-and-reflecting layer on the lower surface of the wavelength conversion layer and the upper surface of the self-luminescence layer includes the following advantages: through the anti-reflection effect from a high refractive index to a low refractive index, selecting multiple materials with different refractive indices effectively reduces the interface light loss between the light emitting surface of the self-luminescence layer and the wavelength conversion layer; and through the design of the first transmitting-and-reflecting layer, the first color light from the bottom self-luminescence layer is fully transmitted, while the converted light emitted downward by the wavelength conversion layer is reflected to the upper surface (as shown in FIG. 2), improving the overall conversion efficiency of the film layer, resulting in a high-brightness color LED chip.

When the second transmitting-and-reflecting layer is present, it is disposed on another surface of the wavelength conversion layer (that is, the surface away from the self-luminescence layer), and is configured to have high reflectivity and low transmissivity for the first color light and low reflectivity and high transmissivity for the second color light; thereby enabling the first color light to be reflected back to the wavelength conversion layer as much as possible for re-conversion while avoiding the first color light from passing through the second transmitting-and-reflecting layer and emitting upward as much as possible, and enabling the second color light emitted from the bottom to pass through the second transmitting-and-reflecting layer and emit upward as much as possible and reflect downward as little as possible. Preparing the second transmitting-and-reflecting layer on the upper surface of the wavelength conversion layer includes the following advantages: through selective light filtering, the unabsorbed first color light within the wavelength conversion layer 30 can be effectively filtered (as shown in FIG. 2, the first color light 101 between the second transmitting-and-reflecting layer 60 and the wavelength conversion layer 30), improving the absorbance of the wavelength conversion layer 30 structure, ensuring the light purity of the sub-pixel area, and improving the overall color gamut of the display screen; and reflecting the unabsorbed first color light 101 back to the wavelength conversion layer, generating secondary absorption conversion, and substantially improving the low-absorption second wavelength conversion layer 32.

In this specification, "high" and "low" have the meanings commonly recognized in the field, generally considered: "high reflectivity" refers to a reflectance of at least greater than 90%; "low reflectivity" refers to a reflectance of at least less than 10%; "high transmissivity" refers to a transmittance of at least greater than 90%; "low transmissivity" refers to a transmittance of at least less than 10%.

In one embodiment, the first transmitting-and-reflecting layer 50 has a reflectance of less than 5% (for example, 5%, 4%, 3%, 2%, or 1%) and a transmittance of greater than 95% (for example, 95%, 96%, 97%, 97.5%, 98%, 98.5%, 99%, 99.5%, or 100%) for the first color light.

Preferably, the first transmitting-and-reflecting layer 50 has a reflectance of less than 3% and a transmittance of greater than 97% for the first color light.

More preferably, the first transmitting-and-reflecting layer 50 has a reflectance of less than 1% and a transmittance of greater than 99% for the first color light.

In one embodiment, the first transmitting-and-reflecting layer 50 has a reflectance of greater than 95% (for example, 95%, 95.5%, 96%, 96.5%, 97%, 97.5%, 98%, 98.5%, 99%, or 100%) and a transmittance of less than 5% (for example, 5%, 4%, 3%, 2%, or 1%) for the second color light.

Preferably, the first transmitting-and-reflecting layer 50 has a reflectance of greater than 97% and a transmittance of less than 3% for the second color light.

In one embodiment, the second transmitting-and-reflecting layer has a reflectance of greater than 95% (for example, 95%, 96%, 97%, 97.5%, 98%, 98.5%, 99%, 99.5%, or 100%) and a transmittance of less than 5% (for example, 5%, 4%, 3%, 2%, or 1%) for the first color light.

Preferably, the second transmitting-and-reflecting layer has a reflectance of greater than 97% and a transmittance of less than 3% for the first color light.

Preferably, the second transmitting-and-reflecting layer has a reflectance of greater than 99% and a transmittance of less than 1% for the first color light.

The second transmitting-and-reflecting layer has a reflectance of less than 10% (for example, 9%, 8%, 7%, 6%, 5%, 4%, 3%, 2%, or 1%) and a transmittance of greater than 90% (for example, 91%, 92%, 93%, 94%, 95%, 95.5%, 96%, 96.5%, 97%, 97.5%, 98%, 98.5%, 99%, 99.5%, or 100%) for the second color light.

Preferably, the second transmitting-and-reflecting layer has a reflectance of less than 5% and a transmittance of greater than 95% for the second color light.

Preferably, the second transmitting-and-reflecting layer has a reflectance of less than 3% and a transmittance of greater than 97% for the second color light.

The wavelength conversion units may include one or more different types of wavelength conversion units and include at least the first wavelength conversion unit 31 for emitting the second color light.

In one embodiment, the wavelength conversion units further include a second wavelength conversion unit 32, and the light emitting units superimposed with the second wavelength conversion unit 32 emit a third color light 321.

The first transmitting-and-reflecting layer 50 is configured to have high reflectivity and low transmissivity for the third color light 321, and the second transmitting-and-reflecting layer 60 is configured to have low reflectivity and high transmissivity for the third color light 321.

In one embodiment, the first transmitting-and-reflecting layer 50 has a reflectance of greater than 90% and a transmittance of less than 10% for the third color light, and the second transmitting-and-reflecting layer has a reflectance of less than 10% and a transmittance of greater than 90% for the third color light.

In one embodiment, the first transmitting-and-reflecting layer 50 has the reflectance of greater than 95% and the transmittance of less than 5% for the third color light, and the second transmitting-and-reflecting layer has the reflectance of less than 5% and the transmittance of greater than 95% for the third color light.

Preferably, the first transmitting-and-reflecting layer 50 has the reflectance of greater than 97% and the transmittance of less than 3% for the third color light, and the second transmitting-and-reflecting layer has the reflectance of less than 3% and the transmittance of greater than 97% for the third color light.

The first transmitting-and-reflecting layer is configured to have high reflectivity and low transmissivity for all colors of light except the first color light, and the specific requirements for reflectance and transmittance refer to the requirements for the reflectance and transmittance of the second color light.

The second transmitting-and-reflecting layer is configured to have low reflectivity and high transmissivity for all colors of light except the first color light, and the specific requirements for reflectance and transmittance refer to the requirements for the reflectance and transmittance of the second-color light.

The wavelength conversion unit includes a material capable of converting the color of light, such as quantum dots and/or phosphors.

In one embodiment, the wavelength conversion unit includes phosphors and/or quantum dots.

According to a specific implementation, the wavelength conversion unit includes quantum dots, and the wavelength conversion units are quantum dot films, such as quantum dot photoresists.

The quantum dot films can be made of conventional materials in the field and prepared in a conventional manner in the field.

In one embodiment, a material of the quantum dot films includes at least one of CdSe, CdS, CdZnSe, CdZnS, CdZnSeS, ZnSeS, ZnSe, CuInS, CuInSe, InP, or InZnP. The quantum dot films can be formed by at least one method of photolithography (for example, by coating, patterning, and curing quantum dot photoresist to obtain quantum dot photoresist), spraying, or printing.

The materials of the first transmitting-and-reflecting layer and the second transmitting-and-reflecting layer are not particularly limited, as long as the materials meet the requirements of the aforementioned transmissivity and refractive index.

In one embodiment, the first transmitting-and-reflecting layer 50 and the second transmitting-and-reflecting layer 60 are each independently a hybrid Bragg reflector (HBR) or a distributed Bragg reflector (DBR).

Due to the photoluminescence properties of quantum dot materials, they have an absorption effect on high-energy light. However, limited by their inherent absorption efficiency, it is difficult to improve color purity. By adding DBR/HBR to the top surface of the film layer, selectively reflecting excitation light and transmitting converted light, the color purity is improved. By adding DBR/HBR to the bottom of the film layer, selectively reflecting converted light and transmitting excitation light generated by the underlying LED, the brightness of the converted light is increased. Therefore, by introducing specific DBR/HBR, blue light can be effectively filtered and converted light can be reflected, thereby achieving the goal of improving color purity and increasing the brightness of converted light, which has profound significance in realizing full-colorization of monochromatic LED devices.

In one embodiment, at least one of the first transmitting-and-reflecting layer and the second transmitting-and-reflecting layer is an HBR. By simultaneously designing both DBR and HBR structures, the cost advantage in DBR design can be ensured while also achieving the highest efficiency quantum dot conversion structure using HBR.

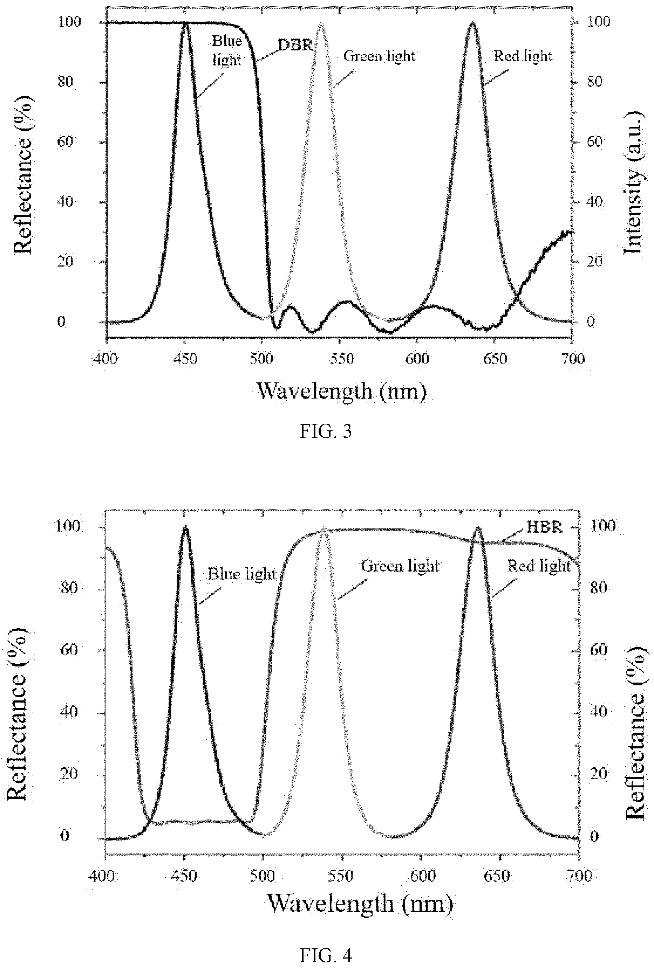

When a first Bragg reflector is an HBR, the reflection curve and spectral diagram are shown, for example, in FIG. 4.

When a second Bragg reflector is a DBR, the reflection curve and spectral diagram are shown, for example, in FIG. 3.

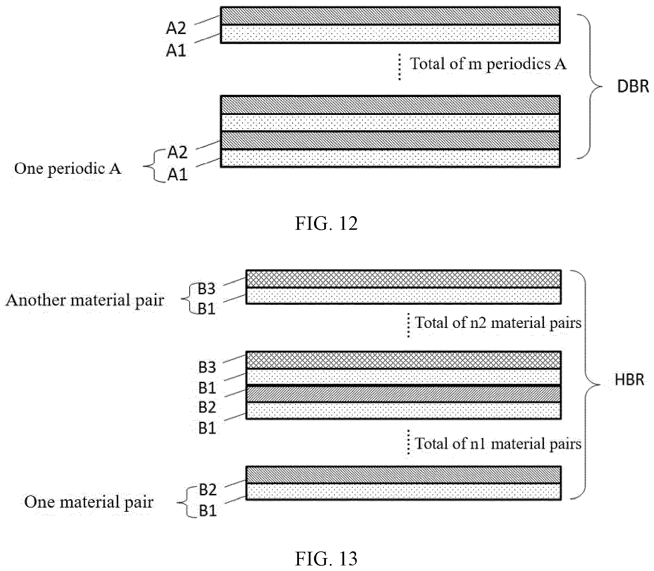

The DBR includes m periodic structures A, where each periodic structure A is formed by stacking a material A1 and a material A2, as shown in FIG. 12. For ease of distinction, it is set that a refractive index of a material A1 is greater than a refractive index of a material A2. The positional relationship between A1 and A2 in the DBR is not limited, meaning A1 can be located below A2 (closer to the self-luminescence layer) or A2 can be located below A1.

In one embodiment, A1 and A2 are each independently selected from TiO₂, SiO₂, SiNₓ, HfO₂, MgF₂, ZrO₂, or polymethyl methacrylate.

In one embodiment, A1 and A2 are SiO₂ and TiO₂, respectively.

In one embodiment, A1 and A2 are MgF₂ and TiO₂, respectively.

In one embodiment, A1 and A2 are SiNₓ and TiO₂, respectively.

In one embodiment, m is a positive integer from 4 to 9 (for example, 4, 5, 6, 7, 8, or 9).

In this specification, the term "distributed Bragg reflector (DBR)" has a meaning substantially consistent with that in the field, specifically "a periodic structure composed of two materials with different refractive indices arranged alternately in an ABAB manner, where the optical thickness of each material layer is 1/4 of the central reflection wavelength". It should be noted that in this specification, the meaning of DBR is not limited to the standard value of "optical thickness being 1/4 of the central reflection wavelength", but allows the thickness to fluctuate within a certain range (for example, within 50% to 200% of the aforementioned standard value).

Therefore, a thickness of each A1 layer is independently = a×[λ_{A1}×1/(4k_{A1})], where λ_{A1} is a reflection wavelength of the material A1, and k_{A1} is a refractive index of the material A1; a thickness of each A2 layer is independently = a×[λ_{A2}×1/(4k_{A2})], where λ_{A2} is a reflection wavelength of the material A2, and k_{A2} is a refractive index of the material A2; a is a thickness adjustment coefficient, and a = 50% ~ 200%, preferably a = 70% ~ 150%, more preferably a = 90% ~ 120%. The role of the coefficient a is to fine-tune the thickness of each layer, so that the resulting DBR can better fit the reflection curve.

In this specification, the term "hybrid Bragg reflector (HBR)" is a term that has never or rarely been used in the field. In this specification, it refers to "when materials of one or more layers in the DBR are changed, so that the materials stacking method does not completely follow the periodic structure of ABAB, the resulting stacked material containing at least three different refractive index materials". Therefore, the HBR is a non-completely periodic stacked material.

The HBR is formed by replacing one or more layers in a periodic stacked material with other materials; where the periodic stacked material includes n periodic structures B, each periodic structure B is formed by stacking a material B1 and a material B2; the another material is one or more materials different from B1 and B2, and denoted as B3... Bx, where x is an integer greater than or equal to 3; n is an integer from 4 to 9 (for example,, 4, 5, 6, 7, 8, or 9).

For ease of distinction, it is set that a refractive index of a material B1 is greater than a refractive index of a material B2. The HBR does not limit the positional relationship between B1 and B2, that is, B1 can be located below B2, or B2 can be located below B1.

The HBR may include only one another material, that is, the HBR is composed of B1, B2, and B3; or it may include multiple another materials, that is, the HBR is composed of B1, B2, B3, B4... (up to Bx).

In one embodiment, B1 and B2 are independently selected from TiO₂, SiO₂, SiNₓ, HfO₂, MgF₂, ZrO₂, or polymethyl methacrylate.

In one embodiment, B1 and B2 are SiO₂ and TiO₂, respectively.

In one embodiment, B1 and B2 are MgF₂ and TiO₂, respectively.

In one embodiment, B1 and B2 are SiNₓ and TiO₂, respectively, where SiNx is a conventional expression for silicon nitride in the field.

The B3... Bx are independently selected from TiO₂, SiO₂, SiNₓ, HfO₂, MgF₂, ZrO₂, or polymethyl methacrylate, and are different from the material selection of B1 and B2 in the HBR.

For ease of description, in this specification, the n periodic structures B formed by stacking a material B1 and a material B2 are represented by the formula "(B1+B2)ₙ", where the brackets represent a repeating unit, and the subscript represents the number of repetitions.

In one embodiment, the HBR is obtained by replacing one or more layers in the (B1 +B2)ₙ stacked material with another material B3.

In one embodiment, the HBR has a stacked structure of (B1+B2)ₙ₁ + (B1/B2 + B3)ₙ₂ (as shown in FIG. 13), where n1 + n2 = n; (B1/B2 + B3) refers to (B1 + B3) or (B2 + B3); that is, the HBR includes n1 periodic structures composed of B1 and B2 and n2 periodic structures composed of B1 or B2 and B3. The (B1 + B2)ₙ₁ + (B1/B2 + B3)ₙ₂ is not limited to the case where the two periodic structures are completely separated, but can also be interleaved, such as the stacking method of (B1 + B2) + (B1 + B3) + (B1 + B2) + (B1 + B2) + (B1 + B3) + ....

In one embodiment, the HBR has a structure of (TiO₂ + SiO₂)ₙ₁ + (TiO₂ + MgF₂)ₙ₂, where n1 is a positive integer from 1 to 3 (for example, 1, 2, or 3), n is a positive integer from 6 to 9, and n2 = n - n1; that is, the HBR includes n1 periodic structures composed of TiO₂ and SiO₂ and n2 periodic structures composed of TiO₂ and MgF₂.

In one embodiment, the HBR has a structure of (TiO₂ + SiNₓ)ₙ₁ + (TiO₂ + MgF₂)ₙ₂, where n1 is a positive integer from 1 to 3 (for example, 1, 2, or 3), n is a positive integer from 6 to 9, and n2 = n - n1; that is, the HBR includes n1 periodic structures composed of TiO₂ and SiNₓ and n2 periodic structures composed of TiO₂ and MgF₂.

In one embodiment, the HBR is obtained by replacing the (B1 + B2)ₙ stacked material with a material B3 and a material B4.

A thickness of each B1 layer is independently = b×[λ_{B1}×1/(4k_{B1})], where λ_{B1} is a reflection wavelength of material B1 and k_{B1} is a refractive index of material B1; a thickness of each B2 layer is independently = b×[λ_{B2}×1/(4k_{B2})], where λ_{B2} is a reflection wavelength of material B2 and k_{B2} is a refractive index of material B2; b is a thickness adjustment coefficient, b = 50% ~ 200%, preferably b = 70% ~ 150%, more preferably b = 90% ~ 120%. A thickness of material B3... Bx is independently = b×[λ_{Bx}×1/(4k_{Bx})], where λ_{Bx} is a reflection wavelength of material Bx and k_{Bx} is a refractive index of material Bx. The role of coefficient b is to fine-tune the thickness of each layer, allowing the resulting HBR to better fit the reflection curve.

Both DBR and HBR can be fitted in simulation software commonly used in the field.

During the fitting process that, in order to achieve the set transmittance and reflectance, the simulation software often adjusts the thickness of one or more layers in the DBR to deviate significantly from the ideal thickness (that is, 1/4 of the central reflection wavelength); when the deviation of a layer's thickness exceeds a certain degree (for example,, greater than 200% or less than 50% of the ideal thickness, preferably greater than 150% or less than 70%, more preferably greater than 120% or less than 90%), the material of that layer can be replaced (when the fitted thickness is too large, replace it with a material with a higher refractive index, when the fitted thickness is smaller, replace it with a material with a lower refractive index), so that the layer thickness is as close as possible to the ideal thickness, thereby obtaining a more effective HBR. Compared to DBR (the reflection curve is shown in FIG. 3, which has secondary peaks in the reflection peak and a single transmission mode), HBR can adjust the reflection curve to have no secondary peaks (as shown in FIG. 4, the reflection curve is smoother), achieving higher reflection for the corresponding wavelength while allowing higher transmission for the other wavelengths, resulting in a brighter and purer conversion spectrum.

In one embodiment, the wavelength conversion layer further includes a plurality of transmission units 33, the transmission units 33 and the wavelength conversion units are separately in a one-to-one correspondence with the light emitting units, forming a periodic arrangement; the transmission units are used to transmit the first color light 101 emitted by the light emitting units; and the second transmitting-and-reflecting layer 60 has vacancies at positions corresponding to the transmission units 33 to transmit the first color light 101.

The transmission units 33 can be holes in the wavelength conversion layer or can be filled with a transparent material (that is, a material that do not affect light waves), such as a transparent glue.

In one embodiment, the first color light 101 is any one of blue light, ultraviolet light, and dual-wavelength light. The dual-wavelength light can be blue light + ultraviolet light, blue light + green light, and the like.

In one embodiment, the first color light is blue light.

As shown in FIG. 1, the wavelength conversion layer 30 includes a plurality of transmission units 33, first wavelength conversion unit 31, and second wavelength conversion unit 32 that are in one-to-one correspondence with the light emitting units 11 and together form a periodic arrangement; where the transmission units 33 are used to emit blue light (that is, the first color light emitted by the light emitting units 11); the first wavelength conversion unit 31 is a red quantum dot film, and the light emitting units 11 superimposed with the first wavelength conversion unit 31 emit red light (that is, the second color light); the second wavelength conversion unit 32 is a green quantum dot film, and the light emitting units 11 superimposed with the second wavelength conversion unit 32 emit green light (that is, the third color light); and at least one transmission unit, at least one red quantum dot film, and at least one green quantum dot film form a pixel.

In another embodiment, the first color light can also be the other high-energy light, such as ultraviolet light.

The quantum dot film layer optical structure of the present disclosure combines Bragg reflectors with quantum dot film layers, through selective light filtering to change the propagation paths of red light, green light, and blue light, thereby obtaining a brighter and purer quantum dot conversion spectrum.

One or more transmission units, one or more first wavelength conversion units, and one or more second wavelength conversion units together form a periodic arrangement, and each periodic arrangement forms a pixel.

The color conversion of the present disclosure is not limited to the conversion of red light, green light, and blue light, but can also include the other light conversions achievable in the field, such as fluorescence conversion.

In one embodiment, the first color light is blue light and/or ultraviolet light; the wavelength conversion units include a first wavelength conversion unit, which is a phosphor film, and the light emitting units superimposed with the first wavelength conversion unit emit fluorescence.

The material and preparation method of the phosphor film can refer to conventional methods in the field. The material of the phosphor film is, for example, selected from at least one of Ce phosphors, (oxy)nitride phosphors, silicate phosphors, Mn⁴⁺ activated fluoride phosphors, and the like.

The micro-display chip disclosed in the present disclosure is particularly suitable for micro-displays, high-resolution displays, near-eye displays, and the like, therefore a size of the micro-display chip disclosed in the present disclosure is extremely small.

In one embodiment, the size of the light emitting units ranges from 1 µm to 50 µm (for example, 1 µm, 5 µm, 10 µm, 15 µm, 20 µm, 25 µm, 30 µm, 40 µm, or 50 µm). In this specification, the "light emitting units" refers to LED light emitting area corresponding to a wavelength conversion unit to emit light of a certain color, which is commonly referred to as "a sub-pixel" in the field.

In one embodiment, a thickness of the first transmitting-and-reflecting layer ranges from 0.5 µm to 1.5 µm (for example, 0.5 µm, 0.6 µm, 0.7 µm, 0.8 µm, 0.9 µm, 1 µm, 1.1 µm, 1.2 µm, 1.3 µm, 1.4 µm, or 1.5 µm), preferably ranges from 1 µm to 1.4 µm.

In one embodiment, a thickness of the wavelength conversion layer ranges from 1.5 µm to 2.5 µm (for example, 1.5 µm, 1.6 µm, 1.7 µm, 1.8 µm, 1.9 µm, 2 µm, 2.1 µm, 2.2µm, 2.3 µm, 2.4 µm, or 2.5 µm).

In one embodiment, a thickness of the second transmitting-and-reflecting layer ranges from 0.5 µm to 1.5 µm (for example, 0.5 µm, 0.6 µm, 0.7 µm, 0.8 µm, 0.9µm, 1 µm, 1.1 µm, 1.2 µm, 1.3 µm, 1.4 µm, or 1.5 µm), preferably ranges from 1 µm to 1.4 µm.

In one embodiment, a thickness ratio of the first transmitting-and-reflecting layer, the wavelength conversion layer, and the second transmitting-and-reflecting layer is (0.3 - 0.8):1:(0.3 - 0.8).

The micro-display chip may also include a conventional material layer in the field, for example, a planarization layer may be set on a surface of the self-luminescence layer to make the surface flat and facilitate the formation of a upper material.

A second aspect of the present disclosure provides a preparation method for preparing a micro-display chip, the preparation method includes the following steps:
(1) forming a first transmitting-and-reflecting layer on a self-luminescence layer provided with a plurality of light emitting units arranged in an array, and the first transmitting-and-reflecting layer is configured to have low reflectivity and high transmissivity for a first color light emitted by the light emitting units;
(2) forming a wavelength conversion layer on a surface of the first transmitting-and-reflecting layer, the wavelength conversion layer is set to include wavelength conversion units, and a film material capable of achieving wavelength conversion is formed at the wavelength conversion units; and
(3) forming a second transmitting-and-reflecting layer on surfaces of the wavelength conversion units, and the second transmitting-and-reflecting layer is configured to have high reflectivity and low transmissivity for the first color light.

The preparation method described in the second aspect of the present disclosure can prepare the micro-display chip described in the first aspect of the present disclosure. To prepare the micro-display chip, the specific components, amounts, and configuration methods of the materials used in the method can be the same as those limited in the first aspect, and will not be repeated here.

In one embodiment, the preparation method further includes: before step (1), providing a driving substrate with a driving circuit, and forming the self-luminescence layer on the driving substrate, the driving substrate can individually light up each of the light emitting units, the light emitting units are LED units or OLED units, and sizes of the light emitting units ranges from 0.1 µm to 10 µm.

The specific structure and formation method of the driving substrate and the self-luminescence layer can be carried out in a conventional manner in the field, in a preferred implementation, the driving substrate and the self-luminescence layer are formed according to the method disclosed in Chinese Patent Application Publication CN112992964A. In one embodiment, a method of forming the self-luminescence layer on the driving substrate includes: providing an LED epitaxial layer, the LED epitaxial layer includes a first doped semiconductor layer, an active layer, and a second doped semiconductor layer; forming a bonding layer on the driving substrate and/or the second doped semiconductor layer and bonding the driving substrate and the second doped semiconductor layer; forming the LED unit on the LED epitaxial layer; and forming an electrical connection structure between the LED unit and the driving substrate so that the driving substrate can individually lighting up each light emitting units.

In one embodiment, the preparation method further includes: the wavelength conversion layer 30 is configured to further include transmissive units 33, the transmissive units 33 and the wavelength conversion units (for example, the first wavelength conversion unit 31 and the second wavelength conversion unit 32 in FIG. 1) are separately in a one-to-one correspondence with the light emitting units 11 and together form a periodic arrangement, and no film material capable of achieving wavelength conversion is formed at the transmissive units to transmit the first color light; and the second transmitting-and-reflecting layer 60 is set to leave vacancies at the positions corresponding to the transmissive units.

In one embodiment, the film material capable of achieving wavelength conversion is a red quantum dot film 31 and/or a green quantum dot film 32. For example, the quantum dot film is a quantum dot photoresist, prepared by mixing a quantum dot solution with a transparent negative photoresist in a certain ratio to prepare a quantum dot photoresist (QDPR) coated on a surface of the first transmitting-and-reflecting layer.

In one embodiment, the first transmitting-and-reflecting layer 50 and the second transmitting-and-reflecting layer 60 are each independently DBR or HBR, and the DBR or HBR is formed by one or more of vapor deposition, sputtering, and deposition.

A method of the vapor deposition includes, for example: using an optical coating machine, selecting different target materials, and evaporating different material optical films layer by layer to form the DBR or the HBR.

A method of the sputtering includes, for example: through magnetron sputtering, using the interaction of magnetic fields and electric fields, and using physical means to sputter the target material layer by layer onto the substrate surface to form the DBR or the HBR.

A method of the deposition includes, for example: through a chemical vapor deposition device, generating solid substances through low chemical reactions and depositing solid substances layer by layer on the substrate to form the DBR or the HBR.

The micro-display chip described in the first aspect of the present disclosure and/or the micro-display chip described in the second aspect of the present disclosure are suitable for application in micro-displays, high-resolution displays, near-eye displays, and the like.

The micro-display chip of the present disclosure, due to its extremely small microscopic size (for example, 4-inch, 6-inch, or 8-inch wafers), has significant advantages in the production of high-resolution display devices and can be used in virtual reality (VR) and augmented reality (AR).

In the present disclosure, the terms "first", "second", and other ordinal numbers are not used to indicate sequence but are only used to distinguish different objects and/or different usage environments; the terms "upper", "lower", "top", "bottom", and other words indicating spatial positions are not used to limit spatial positions in usage states but are only for convenience of description, referring to the spatial position relationships shown in the accompanying drawings.

The present disclosure addresses issues such as poor absorption of quantum dot materials, high reflectivity at the interface between the LED light emitting surface and the quantum dot film layer, reverse light loss in the quantum dot film layer, low color purity of full-color LEDs using quantum dot film layers, and uncertain refractive index of the light emitting surface in mixed quantum dot photoresist preparation; it effectively improves the absorption efficiency and light emission efficiency of the conversion layer, significantly enhances the light emitting effect of low-absorption light (for example, green light), and greatly improves color purity and conversion brightness.

The technical solutions in the embodiments of the present disclosure will be clearly and completely described below with reference to the drawings in the embodiments of the present disclosure. It is obvious that the described embodiments are only a part of the embodiments of the present disclosure, not all of them. Based on the embodiments of the present disclosure, all other embodiments obtained by those of ordinary skill in the art without creative efforts fall within the protection scope of the present disclosure.

In the following examples, unless otherwise specified, the materials used are commercially available analytical grade. The self-luminescence layer used is a blue LED chip, which is a Micro-LED chip with a size of 6-inch wafer. The light emitting units are arranged in an array, with each unit having a side length of 0.19 inches and a pitch of 0.2 inches.

### Example 1

(1) On a surface of a prepared blue self-luminescence layer, an HBR layer was evaporated using an optical coating machine (from bottom to top, layers are stacked as (TiO₂ + SiO₂) + (TiO₂ + SiO₂) + (TiO₂ + SiO₂) + (TiO₂ + SiO₂) + (TiO₂ + SiO₂) + (TiO₂ + MgF₂) + (TiO₂ + MgF₂), totaling 7 pairs; a total thickness is 1.18 µm; a blue light transmittance is 99%, a blue light reflectance is 1%, a red light transmittance is 3%, a red light reflectance is 97%, a green light transmittance is 1%, and a green light reflectance is 99%), and denoted as H1.
(2) On a surface of the HBR layer, a red quantum dot photoresist, a green quantum dot photoresist, and void areas (transmission units) are set at positions corresponding one-to-one with the light emitting units; where preparation methods of the red quantum dot photoresist and the green quantum dot photoresist include: a 300 mg/ml solution (with propylene glycol monomethyl ether acetate (PGMEA) as a solvent) of CdSe/ZnS core-shell quantum dots (a shell thickness of the red quantum dot is 8nm, and a shell thickness of the green quantum dot is 6 nm) and transparent negative photoresist (with PGMEA as a solvent and polymethyl methacrylate PMMA as a main resin) were mixed in a volume ratio of 1:1, then spin-coated on the layer obtained in step (1) under 200 r/min for 100s to obtain a wavelength conversion layer with a film thickness of 2 µm.
(3) On a surface of the wavelength conversion layer, an HBR layer was evaporated using an optical coating machine (from bottom to top, layers are stacked as (TiO₂ + SiO₂) + (TiO₂ + SiO₂) + (TiO₂ + SiO₂) + (TiO₂ + SiO₂) + (TiO₂ + SiO₂) + (TiO₂ + SiO₂) + (TiO₂ + SiO₂) + (TiO₂ + MgF₂) + (TiO₂ + MgF₂), totaling 9 pairs; a total thickness is 1.08 µm; a blue light transmittance is 0.4%, a blue light reflectance is 99.6%, a red light transmittance is 98%, a red light reflectance is 2%, a green light transmittance is 99%, and a green light reflectance is 1%), and denoted as H2.

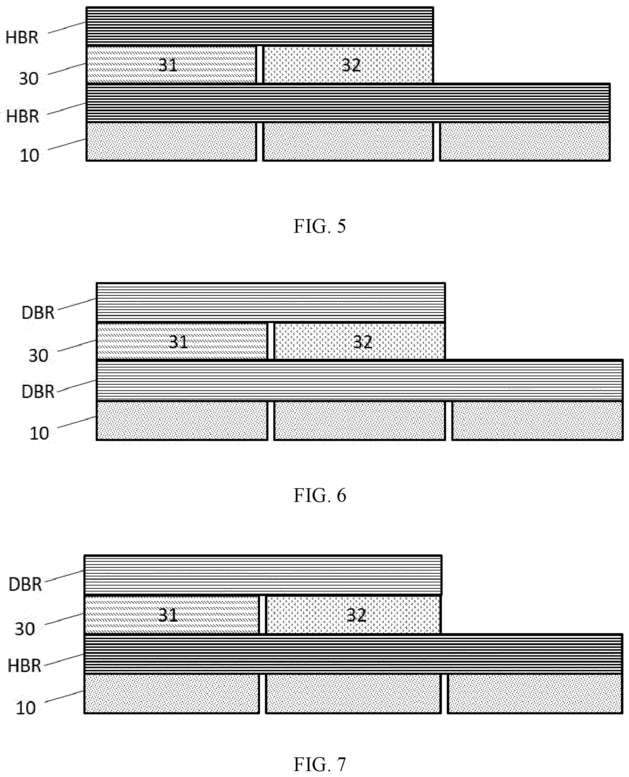

The micro-display chip with a structure of LED-H1-quantum dot film-H2 was obtained, as shown in FIG. 5.

### Example 2

(1) On a surface of a prepared blue LED chip, a DBR layer was evaporated using an optical coating machine (from bottom to top, SiO₂ and TiO₂ form one period, totaling 7 periods; a total thickness is 1.17 µm; a blue light transmittance is 95%, a blue light reflectance is 5%, a red light transmittance is 10%, a red light reflectance is 90%, a green light transmittance is 5%, and a green light reflectance is 95%), and denoted as D1.
(2) A red quantum dot film and a green quantum dot film were formed in the same way as in Example 1.
(3) On a surface of the quantum dot film layer, a DBR layer was evaporated using an optical coating machine (from bottom to top, HfO₂ and MgF₂ form one period, totaling 9 periods; a total thickness is 1.01 µm; a blue light transmittance is 2%, a blue light reflectance is 98%, a red light transmittance is 95%, a red light reflectance is 5%,a green light transmittance is 97%, and a green light reflectance is 3%), and denoted as D2.

The micro-display chip with a structure of LED-D1-quantum dot film-D2 was obtained, as shown in FIG. 6.

### Example 3

This group of examples are used to illustrate the effects of different configuration methods of HBR or DBR.

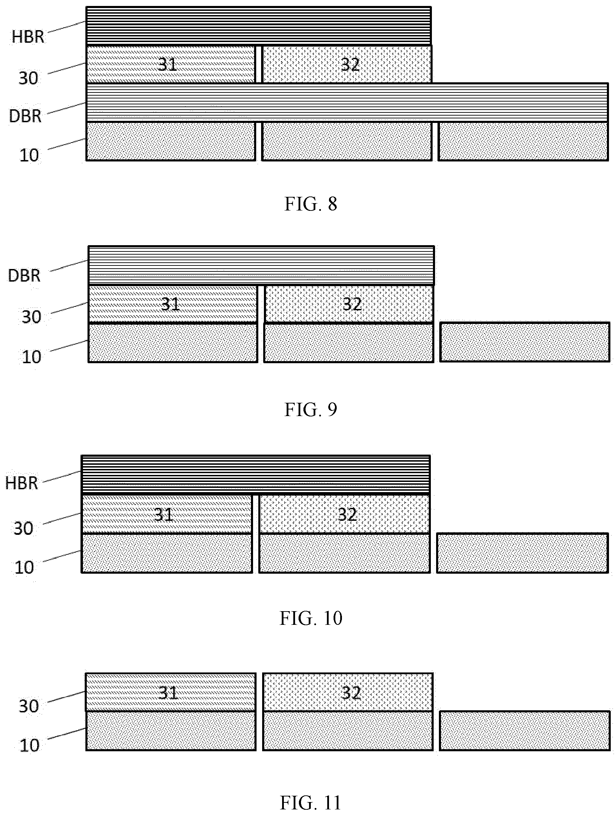

This group of examples were carried out according to Example 1, specifically involving the use of HBR or DBR on the top and bottom layers of the quantum dot film layer, maintaining the same configuration and preparation methods for HBR and DBR as described in Example 1 and Example 2, with the difference being the change in the setting positions of HBR and/or DBR, specifically:
Example 3a, LED-H1-quantum dot film-D2, as shown in FIG. 7.
Example 3b, LED-D1-quantum dot film-H2, as shown in FIG. 8.
Example 3c, LED-no structure-quantum dot film-D2, as shown in FIG. 9.
Example 3d, LED-no structure-quantum dot film-H2, as shown in FIG. 10.
Example 4

This group of examples were used to illustrate the impact when changing the specific material and/or structure of HBR.

This group of examples were carried out according to Example 3a, except that the material combination, a number of stacked layers in a period, or a number of periods in HBR were changed respectively; the other layers except HBR remain unchanged specifically.

Example 4a, the H1 layer was replaced with a new HBR layer (TiO₂ + SiNₓ) + (TiO₂ + SiNₓ) + (TiO₂ + SiNₓ) + (TiO₂ + SiNₓ) + (TiO₂ + SiNₓ) + (TiO₂ + MgF₂) + (TiO₂ + MgF₂) totaling 7 pairs, with a total thickness of 1.19 µm; a blue light transmittance is 98%, a blue light reflectance is 2%, a red light transmittance is 3%, a red light reflectance is 97%, a green light transmittance is 1%, a green light reflectance is 99%, and was denoted as H3.

Example 4b, the H1 layer was replaced with a new HBR layer (TiO₂ + SiNₓ) + (TiO₂ + SiNₓ) + (TiO₂ + SiNₓ) + (TiO₂ + SiNₓ) + (TiO₂ + SiNₓ) + (TiO₂ + SiNₓ) + (TiO₂ + MgF₂) totaling 7 pairs, with a total thickness of 1.20 µm; a blue light transmittance is 98%, a blue light reflectance is 2%, a red light transmittance is 4%, a red light reflectance is 96%, a green light transmittance is 2%, a green light reflectance is 98%, and was denoted as H4.

Example 4c, the H1 layer was replaced with a new HBR layer (TiO₂ + SiO₂) + (TiO₂ + SiO₂) + (TiO₂ + SiO₂) + (TiO₂ + SiO₂) + (TiO₂ + SiO₂) + (TiO₂ + SiO₂) + (TiO₂ + MgF₂) totaling 7 pairs, with a total thickness of 1.19 µm; a blue light transmittance is 98%, a blue light reflectance is 2%, a red light transmittance is 4%, a red light reflectance is 96%, a green light transmittance is 2%, a green light reflectance is 98%; and the resulting HBR layer was denoted as H5.

### Comparative Example 1

Refer to Example 1, except that the top and bottom layers of the quantum dot film layer have no structure, that is, LED-no structure-quantum dot film-no structure, as shown in FIG. 11.

### Test Example

The products obtained from the examples and comparative example were subjected to the following tests.

### (1) Conversion light brightness (unit: nits) and absorbance OD for red light and green light

Using a spectrometer, the vertical surface-emitted light brightness (results were recorded in Table 1) of red and green pixel area within a 100 µm aperture was measured, and the emission spectrum was obtained, and ratios of red/blue and red/green light were determined by integrating the spectrum, thereby the absorbance OD (results were recorded in Table 2) to the light source was obtained.

### (2) Color purity (unit: %)

Using an integrating sphere/spectrometer, the red-blue; green-blue dual-band spectrums were measured, the light power was measured, and the ratio of red light power to total light power in the red pixel (results were recorded in Table 3) was calculated, and similarly the ratio of green light power to total light power in the green pixel (results were recorded in Table 3) was calculated.

**Table 1**

| | First structure/Second structure | Conversion light brightness (Red)/nits | Conversion light brightness (Green)/nits |
|---|---|---|---|
| Example 1 | H1/H2 | 251K | 478K |
| Example 2 | D1/D2 | 172K | 353K |
| Example 3a | H1/D2 | 189K | 385K |
| Example 3b | D1/H2 | 198K | 411K |
| Example 3c | No structure/D2 | 110K | 233K |
| Example 3d | No structure/H2 | 156K | 256K |
| Example 4a | H3/D2 | 192K | 413K |
| Example 4b | H4/D2 | 183K | 387K |
| Example 4c | H5/D2 | 181K | 384K |
| Comparative Example 1 | No structure/No structure | 80K | 150K |

**Table 2**

| | First structure/Second structure | Film layer absorbance OD (Red) | Film layer absorbance OD (Green) |
|---|---|---|---|
| Example 1 | H1/H2 | 2.6 | 2.0 |
| Example 2 | D1/D2 | 2.5 | 1.9 |
| Example 3a | H1/D2 | 2.6 | 2.0 |
| Example 3b | D1/H2 | 2.5 | 1.9 |
| Example 3c | No structure/D2 | 2.2 | 1.6 |
| Example 3d | No structure/H2 | 2.3 | 1.7 |
| Example 4a | H3/D2 | 2.6 | 2.0 |
| Example 4b | H4/D2 | 2.6 | 2.0 |
| Example 4c | H5/D2 | 2.6 | 2.0 |
| Comparative Example 1 | No structure/No structure | 0.7 | 0.3 |

**Table 3**

| | First structure/Second structure | Red Light Color Purity/% | Green Light Color Purity/% |
|---|---|---|---|
| Example 1 | H1/H2 | 99.9% | 99.3% |
| Example 2 | D1/D2 | 99.7% | 99.0% |
| Example 3a | H1/D2 | 99.7% | 99.0% |
| Example 3b | D1/H2 | 99.9% | 99.3% |
| Example 3c | No structure/D2 | 96.7% | 97.0% |
| Example 3d | No structure/H2 | 93.9% | 94.3% |
| Example 4a | H3/D2 | 99.8% | 99.2% |
| Example 4b | H4/D2 | 99.8% | 99.2% |
| Example 4c | H5/D2 | 99.8% | 99.3% |
| Comparative Example 1 | No structure/No structure | 78.1% | 50.2% |

As can be learned from the tables, the micro-display chips of the examples can achieve significantly better conversion light brightness, absorbance, and color purity compared to the comparative examples.

The preferred examples of the present disclosure have been described in detail above, but the present disclosure is not limited thereto. Within the technical concept scope of the present disclosure, various simple modifications can be made to the technical solutions of the present disclosure, including combining various technical features in any other suitable manner. These simple modifications and combinations should also be regarded as the content disclosed by the present disclosure, and all fall within the protection scope of the present disclosure.

## Claims

1. A micro-display chip, comprising:
a self-luminescence layer (10), the self-luminescence layer (10) comprises a plurality of light emitting units (11) arranged in an array, each of the light emitting units (11) is capable of being individually lit up, the light emitting units (11) are configured to emit a first color light (101); and
a wavelength conversion layer (30), disposed on a surface of the self-luminescence layer (10), the wavelength conversion layer (30) comprises a plurality of wavelength conversion units, the wavelength conversion units comprise at least a first wavelength conversion unit (31), the light emitting units (11) superimposed with the first wavelength conversion unit (31) emit a second color light (311);
**characterized in that**,
the micro-display chip further comprises: a first transmitting-and-reflecting layer (50) and/or a second transmitting-and-reflecting layer (60);
the first transmitting-and-reflecting layer (50) is configured to be disposed between the self-luminescence layer (10) and the wavelength conversion layer (30);
the second transmitting-and-reflecting layer (60) is configured to be disposed on another surface of the wavelength conversion layer (30); and
the first transmitting-and-reflecting layer (50) is configured to have low reflectivity and high transmissivity for the first color light (101) and high reflectivity and low transmissivity for the second color light (311), and the second transmitting-and-reflecting layer (60) is configured to have high reflectivity and low transmissivity for the first color light (101) and low reflectivity and high transmissivity for the second color light (311).

2. The micro-display chip according to claim 1, wherein the micro-display chip further comprises a driving substrate with a driving circuit, the self-luminescence layer is disposed on the driving substrate, the driving substrate is capable of individually lighting each of the light emitting units (11), the light emitting units (11) are LED units or OLED units, and a size of the light emitting units (11) ranges from 0.1 µm to 10 µm.

3. The micro-display chip according to claim 1 or 2, wherein the first transmitting-and-reflecting layer (50) has a reflectance of less than 5% and a transmittance of greater than 95% for the first color light (101); and/or
the first transmitting-and-reflecting layer (50) has a reflectance of greater than 90% and a transmittance of less than 10% for the second color light (311).

4. The micro-display chip according to any one of claims 1 to 3, wherein the second transmitting-and-reflecting layer (60) has a reflectance of greater than 95% and a transmittance of less than 5% for the first color light (101); and/or
the second transmitting-and-reflecting layer (60) has a reflectance of less than 10% and a transmittance of greater than 90% for the second color light (311).

5. The micro-display chip according to any one of claims 1 to 4, wherein the wavelength conversion units further comprise a second wavelength conversion unit (32), and the light emitting units (11) superimposed with the second wavelength conversion unit (32) emit a third color light (321); and
the first transmitting-and-reflecting layer (50) is further configured to have high reflectivity and low transmissivity for the third color light (321), and the second transmitting-and-reflecting layer (60) is further configured to have low reflectivity and high transmissivity for the third color light (321);
preferably, the first transmitting-and-reflecting layer (50) has a reflectance of greater than 90% and a transmittance of less than 10% for the third color light (321), and the second transmitting-and-reflecting layer (60) has a reflectance of less than 10% and a transmittance of greater than 90% for the third color light (321).

6. The micro-display chip according to any one of claims 1 to 5, wherein the wavelength conversion units comprise quantum dots and/or phosphors;
preferably, the wavelength conversion units comprise a photoresist.

7. The micro-display chip according to any one of claims 1 to 6, wherein the first transmitting-and-reflecting layer (50) and the second transmitting-and-reflecting layer (60) are each independently a hybrid Bragg reflector or a distributed Bragg reflector;
wherein the distributed Bragg reflector comprises m periodic structures A, and each periodic structure A is formed by stacking a material A1 and a material A2, m is an integer from 4 to 9;
the hybrid Bragg reflector is formed by replacing one or more layers in a periodic stacked material with another material; wherein the periodic stacked material comprises n periodic structures B, and each periodic structure B is formed by stacking a material B1 and a material B2; the another material is one or more materials different from B1 and B2, and denoted as B3... Bx, wherein x is an integer greater than or equal to 3; n is an integer from 4 to 9; and
the materials A1, A2, B1, B2, B3... Bx are each independently selected from TiO₂, SiO₂, SiNₓ, HfO₂, MgF₂, ZrO₂, or polymethyl methacrylate.

8. The micro-display chip according to claim 7, wherein the hybrid Bragg reflector comprises n1 periodic structures composed of B1 and B2 and n2 periodic structures composed of B1 or B2 and B3, and n1 + n2 = n;
preferably, the hybrid Bragg reflector comprises n1 periodic structures composed of TiO₂ and SiO₂ and n2 periodic structures composed of TiO₂ and MgF₂, wherein n1 is a positive integer from 1 to 3, n is a positive integer from 6 to 9, and n2 = n - n1; or
the hybrid Bragg reflector comprises n1 periodic structures composed of TiO₂ and SiNₓ and n2 periodic structures composed of TiO₂ and MgF₂, wherein n1 is a positive integer from 1 to 3, n is a positive integer from 6 to 9, and n2 = n - n1.

9. The micro-display chip according to any one of claims 1 to 8, wherein the wavelength conversion layer further comprises a plurality of transmission units (33), and the transmission units are disposed on part of the multiple light emitting units (11) and used to transmit the first color light (101) emitted by the corresponding light emitting units (11); and
the second transmitting-and-reflecting layer (60) has vacancies at positions corresponding to the transmission units (33) to transmit the first color light (101).

10. The micro-display chip according to any one of claims 1 to 9, wherein the first color light (101) is blue light;
the wavelength conversion layer (30) comprises a plurality of transmission units (33), first wavelength conversion units (31), and second wavelength conversion units (32) that are in one-to-one correspondence with the light emitting units (11) and together form a periodic arrangement; wherein the transmission units (33) are used to transmit the blue light; the first wavelength conversion unit (31) is a red quantum dot film, and the light emitting units (11) superimposed with the first wavelength conversion unit (31) emit red light; and the second wavelength conversion unit (32) is a green quantum dot film, and the light emitting units (11) superimposed with the second wavelength conversion unit (32) emit green light; and
at least one transmission unit (33), at least one first wavelength conversion unit (31), and at least one second wavelength conversion unit (32) form a pixel.

11. A preparation method of a micro-display chip, **characterized in that**, the preparation method comprises the following steps:
(1) forming a first transmitting-and-reflecting layer (50) on a self-luminescence layer provided with a plurality of light emitting units (11) arranged in an array, and the first transmitting-and-reflecting layer (50) is configured to have low reflectivity and high transmissivity for a first color light (101) emitted by the light emitting units (11);
(2) forming a wavelength conversion layer (30) on a surface of the first transmitting-and-reflecting layer (50), wherein the wavelength conversion layer (30) comprises a plurality of wavelength conversion units, the wavelength conversion units comprise at least a first wavelength conversion unit (31), and the light emitting units (11) superimposed with the first wavelength conversion unit (31) emit a second color light (311); and
(3) forming a second transmitting-and-reflecting layer (60) on surfaces of the wavelength conversion units, and the second transmitting-and-reflecting layer (60) is configured to have high reflectivity and low transmissivity for the first color light (101).

12. The preparation method according to claim 11, wherein, the preparation method further comprises: providing a driving substrate with a driving circuit, and forming the self-luminescence layer on the driving substrate, wherein the driving substrate is capable of individually lighting up each of the light emitting units (11), the light emitting units (11) are LED units or OLED units, and sizes of the light emitting units ranges form 0.1 µm to 10 µm.

13. The preparation method according to claim 11 or 12, wherein the first transmitting-and-reflecting layer (50) and the second transmitting-and-reflecting layer (60) are each independently a hybrid Bragg reflector or a distributed Bragg reflector;
wherein the distributed Bragg reflector comprises m periodic structures A, and each periodic structure A is formed by stacking a material A1 and a material A2, m is an integer from 4 to 9;
the hybrid Bragg reflector is formed by replacing one or more layers in a periodic stacked material with another material; wherein the periodic stacked material comprises n periodic structures B, and each periodic structure B is formed by stacking a material B1 and a material B2; the another material is one or more materials different from B1 and B2, and denoted as B3... Bx, wherein x is an integer greater than or equal to 3; n is an integer from 4 to 9;
the materials A1, A2, B1, B2, B3... Bx are each independently selected from TiO₂, SiO₂, SiNₓ, HfO₂, MgF₂, ZrO₂, or polymethyl methacrylate; and
the hybrid Bragg reflector and the distributed Bragg reflector are each independently formed by one or more of vapor deposition, sputtering, or deposition.

14. The preparation method according to any one of claims 11 to 13, wherein the preparation method further comprises: the wavelength conversion layer (30) is configured to further comprise transmission units (33), and the transmission units (33) are disposed on part of the multiple light emitting units (11) and used to transmit the first color light (101) emitted by the corresponding light emitting units (11); and
the second transmitting-and-reflecting layer (60) has vacancies at positions corresponding to the transmission units (33) to transmit the first color light (101).

15. The preparation method according to any one of claims 12 to 14, wherein a method for forming the self-luminescence layer on the driving substrate comprises:
providing an LED epitaxial layer, and the LED epitaxial layer comprises a first doped semiconductor layer, an active layer, and a second doped semiconductor layer;
forming a bonding layer on the driving substrate and/or the second doped semiconductor layer and bond the two;
forming the LED unit on the LED epitaxial layer; and
forming an electrical connection structure between the LED unit and the driving substrate so that the driving substrate is capable of individually lighting up each of the light emitting units (11).
